# EUROPEAN PATENT APPLICATION

(11) **EP 0 604 061 A1**
(43) Date of publication of application: **29.06.1994**
(21) Application number: 93309852.7
(22) Date of filing: 08.12.1993
(51) Int. Cl.: B28D 5/00, B28D 1/00, H01L 21/02, H01L 23/544

(54) **Semiconductor fabrication**

(30) Priority: 24.12.1992 US 996456
(71) Applicant: AT&T Corp., New York, NY 10013-2412 (US)
(72) Inventor: Koeneke, Conrad Jose, Allentown, Pennsylvania 18103 (US)
(74) Representative: Johnston, Kenneth Graham

(57) **Abstract**

A method of semiconductor wafer marking and identification is disclosed. Identifying notches (e.g., 23), akin to bar codes, are cut into the edge (e.g., 27) of the wafer (e.g., 25), illustratively on a flat (e.g., 500). The notches may be read by laser-equipped bar code reading apparatus at various stages of wafer (e.g., 25) processing.

## Description

### Technical Field

This invention relates to semiconductor integrated circuit fabrication.

### Background of the Invention

Current methods of semiconductor integrated circuit fabrication involve the formation of individual integrated circuits upon semiconductor wafers which have previously been cut from bars of semiconductor material. Various identifying marks are often placed upon the face (and/or backside) of the wafer between individual circuits to identify the wafer as it travels throughout the manufacturing process. The identifying marks may identify the bar (ingot) number, and various other details unique to the wafer. Unfortunately, the identifying marks tend to attract dirt and other contaminants which interfere with the subsequent successful formation and processing of individual integrated circuits upon the face of the wafer. If the marks are placed upon the face of the wafer, the total number of integrated circuits which may be placed upon the wafer may be diminished. Furthermore, if the marks are made too shallow (to minimize attraction of dirt, etc.), the marks may be obliterated during subsequent processing.

### Summary of the Invention

The above-mentioned problems are solved by the present invention which illustratively includes forming a plurality of notches on the edge of a wafer or an ingot.

### Brief Description of the Drawings

FIG. 1 is a perspective view of a semiconductor ingot being marked in an illustrative embodiment of the present invention;
FIG. 2 is a perspective view of a semiconductor wafer marked with an identifying mark in accordance with an illustrative embodiment of the present invention;
FIG. 3 is an enlarged perspective view of a portion of the semiconductor wafer illustrated in FIG. 2; and
FIG. 4 is an enlarged perspective view of another illustrative embodiment.

### Detailed Description

Applicant has discovered that a wafer may be identified by creating a series of notches, in a pattern akin to that employed by users of bar codes, in the *edge* of semiconductor wafers. The edge markings may be subsequently "read" by bar code reading machinery utilizing, typically, a laser. Applicant's edge markings are not as susceptible to attracting dirt as markings placed upon the face of the wafer.

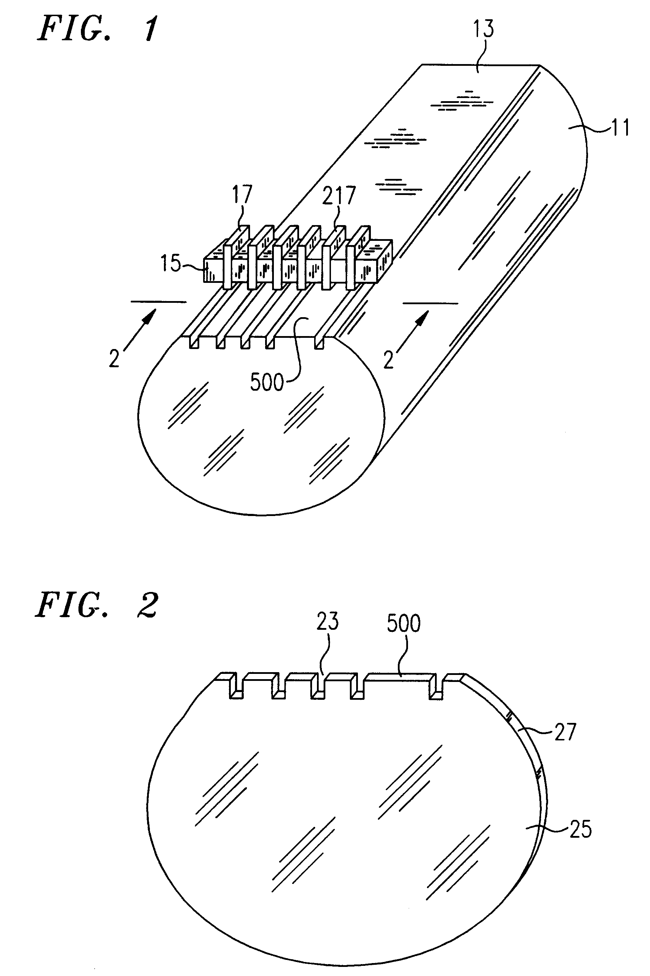

In FIG. 1 reference numeral 11 denotes a semiconductor ingot having a flat 13. Scriber 15 has a series of parallel mechanical cutters 17 arranged at preselected intervals and positioned to cut notches into flat 13 of ingot 11. Alternatively, reference numeral 17 may designate a series of lasers suitable for cutting notches into flat 13 of ingot 11.

Typically, in the past, wafers have been identified by scribing a lot number and wafer number using an ultrasound diamond scriber or laser scriber. The scribing is done on the polished side of the wafer so that it may be observed without turning the wafer. As mentioned before, the method of preference, laser scribing, leaves many irregularities on the surface which can catch dirt and release them later in sensitive layers of the equipment, creating unwanted contamination, and, possibly, adversely affecting yield.

FIG. 2 illustrates notches 23 having been inscribed upon flat 13 of wafer 25.

Examination of FIGS. 1 and 2 shows that cutters or lasers such as 17 create notches 23. However, if a cutter or lasre 217 is not engaged or operated, a flat region 500 is obtained.

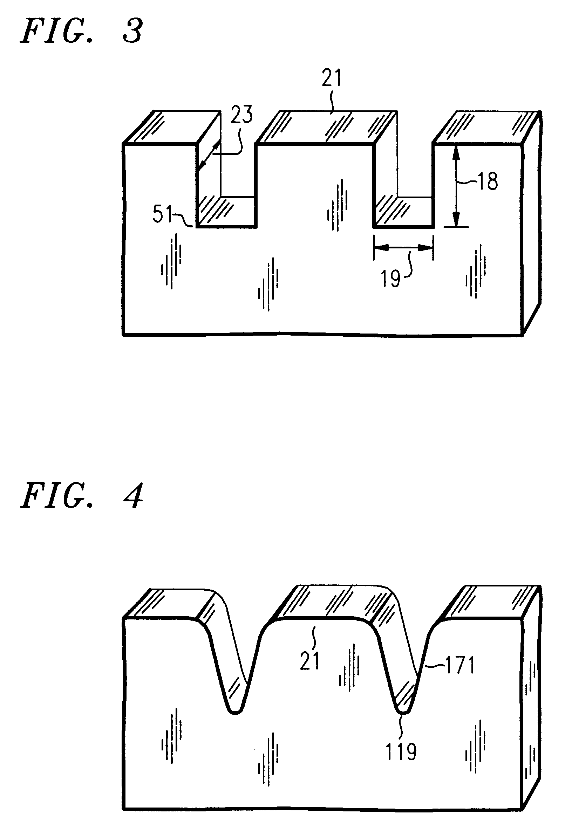

Illustratively, as shown in FIG. 3, the depth 18 and width 19 of each notch may be 500µm and 100µm, respectively. The spacing 21 between successive notches may be 1000µm. The thickness 23 of the notches is the same as the thickness of the wafer, or approximately 20 mils (i.e., 500µm) for a typical five inch diameter wafer. The dimensions are quite adequate for detection by typical bar code scanners in current use which have spot sizes of approximately 0.2µm. Thus every inch of flat 13 may have 25 bars which correspond to 2²⁵ or 7.4 x 10¹⁰ different combinations per inch. The notches may be cut on the wafer flat before the wafer is cut from the ingot as shown in FIG. 1. As soon as flat 13 is cut, a series of mechanical cutters or lasers 17 may carve the notches sequentially along the direction of the ingot.

It is generally advisable to soften or smooth sharp corners such as corner 51. Mechanical polishing may be employed to soften or smooth features 18, 21, and 19, changing them to 171, 121, and 119, respectively, as illustrated in FIG. 4. Alternatively, the notches with smoothed corners shown in FIG. 4 may be obtained by using correspondingly shaped mechanical cutters 17 or modulated lasers 17. Reading of the bar codes at various times during wafer processing may be performed by a laser scanning apparatus similar to that employed in current grocery store checkout counters.

A disadvantage of the present scheme is that an operator will not be able to directly read the code upon the wafer. However, machine reading of the edge markings of an entire cassette may become feasible and machine readers may be placed at various locations upon the production floor. The method possesses an advantage in that an enormous amount of combinations may be scribed upon the flat of a wafer. Scribing on a flat 13 is not essential, for example, scribing on the cylindrical outside surface of the wafer 27 is also possible. Pre-aligning the marking area properly to the crystallographic axes makes the use of a flat or other orientation structure unnecessary.

## Claims

1. A method of semiconductor integrated circuit fabrication comprising the step CHARACTERIZED BY:
forming a plurality of notches (e.g., 23) in the edge (e.g., 27) of a wafer (e.g., 25).

2. The method of claim 1 in which said notches (e.g., 23) contain identification information and further including the step of reading said information.

3. The method of claim 1 in which said notches (e.g., 23) are formed by cutting wheels.

4. The method of claim 1 in which said notches (e.g., 23) are formed by a laser (e.g., 17).

5. The method of claim 1 in which said notches (e.g., 23) are approximately 2µm wide and 20µm deep.

6. A method of semiconductor integrated circuit fabrication comprising the step CHARACTERIZED BY:
forming a plurality of notches (e.g., 23) in the edge (e.g., 13) of a semiconductor ingot (e.g., 11); and
sawing the ingot into wafers.

7. A semiconductor wafer (e.g., 25) comprising an edge (e.g., 27), AND CHARACTERIZED BY said edge (e.g., 27) having notches (e.g., 23).
